# EUROPEAN PATENT SPECIFICATION

(11) **EP 1 894 712 B1**
(45) Date of publication and mention of the grant of the patent: **06.04.2011**
(21) Application number: 07468006.7
(22) Date of filing: 21.05.2007
(51) Int. Cl.: B32B 15/08, B32B 17/06, H03K 17/96

(54) **Touch sensitive foil and a switch made thereof**
Berührungsempfindliche Folie und daraus hergestellter Schalter
Feuille tactile et interrupteur fabriqué avec

(30) Priority: 28.08.2006 SI 200600193
(43) Date of publication of application: 05.03.2008
(73) Proprietor: Gorenje Gospodinjski aparati d.d., 3503 Velenje (SI)
(72) Inventor: Dermol, Joze, 3327 Smartno ob Paki (SI)
(74) Representative: Ivancic, Bojan

(56) References cited:
- GB-A- 2 016 704
- GB-A- 2 090 979
- GB-A- 2 234 352

## Description

The present invention refers to a touch sensitive foil, in particularly to a foil for producing a switch in household appliances, preferably with baking ovens, where said switch is formed of a plurality of layers arranged on top of each other and mutually interconnected.

A user interface controlled by the user without contact through a glass is used nowadays with household appliances. With such an interface the sensor is separated from the symbol of the associated function, an oven for instance. The symbols are plotted on the front foil and become visible by means of a transillumination using LED light fields for instance. In order for the said fields to be illuminated the associated circuit must be spaced from the glass which requires placement of additional elastic elements on sensors that transfer the sensor function onto the glass. Such a solution has several disadvantages, such as extension of the control module beyond the sensor fields. In addition, the sensors must be equipped with an additional print on the control panel. Furthermore, each sensor requires an additional element by means of which the distance between the circuit and the control panel is bridged.

The use of membrane keyboards is known, consisting usually of two layers where conductors and switches are deposited. Each sensor and switch, respectively, is connected via the control electronic circuit with two electric poles, said sensor and switch, respectively, establishes an electric contact when pressed. The keyboards as described cannot be installed under the glass or any other solid surface.

Further, the use of the front foil for the aforementioned purposes is known representing a decorative part of the membrane keyboard. The electric function is provided in this case by means of mechanical keys arranged on the circuit below the foil. Also this kind of solution is not suitable for the installation under the glass or any other solid surface.

Another known solution provides the use of so called resistor foils which are not suitable for use with high temperatures which occur with baking ovens for instance.

A touch switch as described above has been disclosed in the patent application GB-A-2 234 352. According to said patent application, multiple conducting levels are provided in order for each sensor of a touch switch to operate. A touch switch is also disclosed in patent applications GB-A-2 090 979 and GB-A-2 016 704, however, said documents merely represent a technological background and does not provide any new information that would help overcoming the problems as described above.

It is the object of the present invention to create a new touch sensitive switch for use with household appliances, preferably with baking ovens.

The object as set above is solved by a layer of a conductive material being arranged on a first carrier layer, and above the layer of the conductive material there is arranged a second carrier layer, on top of which it is placed a colour layer. The first carrier layer provided with the layer of the conductive material and the second carrier layer provided with the colour layer are mutually interconnected by means of an adhesive layer. The entire assembly of the said layers is fixed by means of an adhesive to the carrier layer made of glass, for instance.

It is provided for according to the present invention that said layer of the conductive material is placed onto said first carrier layer preferably using a printing process, and that said colour layer is placed onto said second carrier layer preferably using a printing process.

Said layer of the conductive material is divided at least into one touch sensitive field, where each of said touch sensitive fields is connected via one single electric pole with a control electronic module. Practically it is provided for that said layer of the conductive material is divided into plurality of touch sensitive fields each of them being adjusted to a certain function of the baking oven.

Each of said touch sensitive fields is charged by means of the control electronic module and via flexible flat conductor cable with an electric charge, where the electric charge of each touch sensitive field differs essentially from the electric charge of the user of the appliance. When the user touches each of the touch sensitive fields the result thereof is a disruption of the electric charge being detected by the control electronic module which controls the oven accordingly.

The present invention will become more fully understood from the detailed description given hereinafter and the accompanying drawings, wherein
- Fig. 1: shows a cross-sectional view of a touch sensitive foil according to the invention, and
- Fig. 2: shows a top view of a touch sensitive foil of Fig. 1 for use with a baking oven.

A touch sensitive foil, of which a touch sensitive switch is made, consists of a plurality of layers placed above each other and mutually interconnected. On top of a first carrier layer 1 there is arranged a second layer 2 of a conductive material which is attached to the first carrier layer 1 preferably by means of a printing process. Above the layer 2 of the conductive material there is arranged a second carrier layer 3 on top of which there is attached a colour layer 4, preferably by means of a printing process. The first carrier layer 1 provided with the layer 2 of the conductive material, and the second carrier layer 3 provided with the colour layer 4 are mutually interconnected by means of a layer 5 of an adhesive means, preferably cement. The entire assembly of layers 1 to 5 is attached, by means of an adhesive means 6, to a carrier layer 7 made of glass, for instance. It is provided for according to the invention that the first carrier layer 1 and the second carrier layer 3 are made of a synthetic material having sufficient strength and which is high temperature resistant.

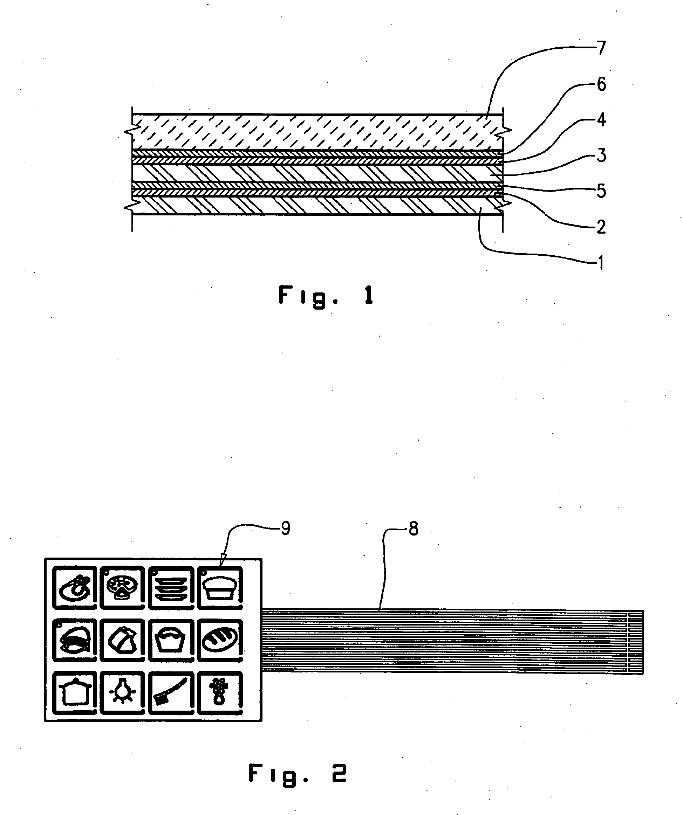

Said layer 2 of the conductive material is connected via so called flexible flat conductor cable 8, which is an integral part of the touch sensitive foil according to the invention, and via a single electrical pole with a control electronic modul, not shown. When the touch sensitive foil according to the invention is used for controlling an oven by means of a control panel, for example, said foil resembles the form which suits best to each household appliance being controlled. Here, said layer 2 of the conductive material in the touch sensitive foil is formed with at least one touch sensitive field, and in practice with a plurality of the touch sensitive fields 9 (Fig. 2 shows each field marked with a thick line). Each of said touch sensitive fields 9 is electrically charged by means of the control electronic module and via the flexible flat conductor cable 8 with a predetermined electrical charge which, however, is essentially lower than the electrical charge of a user of the appliance. When the user approaches the certain field 9, with a finger for instance, intending to activate certain function of the oven the user disrupts with his electrical charge the said electrical charge of the said touch sensitive field 9. Said control electronic module senses via the cable 8 said disruption of said touch sensitive field 9 and activates the appropriate function of the oven set by the user.

According to the invention it is provided for that the above mentioned layer 2 of the conductive material is divided into the number of the touch sensitive fields 9 that suits the oven, where each of the fields 9 is provided with a suitable sign and pictogram, respectively, representing a user friendly graphical interface. Said pictogram of each touch sensitive field 9 is formed as a light permeable field, in particular when the pictogram is illuminated from below. In this way, a function of a sensor and a symbol which can be easy recognized by the user is simultaneously assigned to each field 9.

## Claims

1. A touch sensitive foil formed of a plurality of layers arranged on top of each other and mutually interconnected, ***characterized in that*** on top of a first carrier layer (1) there is arranged a layer (2) of a conductive material, and on top of the layer (2) of the conductive material is arranged a second carrier layer (3) on top of which is attached a colour layer (4), where the first carrier layer (1) provided with the layer (2) of the conductive material and the second carrier layer (3) provided with the colour layer (4) are mutually interconnected by means of a layer (5) of an adhesive means, and where the entire assembly of the layers (1) to (5) is attached by means of an adhesive means (6) to a carrier layer (7) made of glass.

2. A touch sensitive foil according to claim 1, ***characterized in that*** said layer (2) of the conductive material is placed onto said first carrier layer (1) preferably by means of a printing process.

3. A touch sensitive foil according to claim 1*,* ***characterized* in *that*** said colour layer (4) is placed onto said second carrier layer (3) preferably by means of a printing process.

4. A touch sensitive switch, preferably for a baking oven, made of a touch sensitive foil according to claims 1 to 3, ***characterized in that*** said layer (2) of the conductive material is formed as at least one touch sensitive field (9), each of said touch sensitive fields (9) being connected via a single electrical pole with a control electronic module.

5. A touch sensitive switch according to claim 4, ***characterized in that*** each of said touch sensitive fields (9) is charged by means of a control electronic module and via a flexible flat conductor cable (8) with an electric charge.

6. A touch sensitive switch according to claims 4 and 5, ***characterized in that*** the electrical charge of each touch sensitive field (9) differs essentially from an electrical charge of a user.

7. A touch sensitive switch according to any of claims 4 to 6, ***characterized* in *that*** a pictogram of each touch sensitive field (9) is formed so as to allow the light to pass through when illuminated from below.

## Patentansprüche

1. Berührungsempfindliche Folie, die aus einer Vielzahl von Schichten ausgebildet ist, die übereinander angeordnet und gegenseitig verbunden sind, ***dadurch gekennzeichnet,* dass** auf einer ersten Trägerschicht (1) eine Schicht (2) aus einem leitenden Material angeordnet ist und auf der Schicht (2) aus dem leitenden Material eine zweite Trägerschicht (3) angeordnet ist, auf der eine Farbschicht (4) angebracht ist, wobei die erste Trägerschicht (1), die mit der Schicht (2) des leitenden Materials versehen ist, und die zweite Trägerschicht (3), die mit der Farbschicht (4) versehen ist, mittels einer Schicht (5) aus einem Klebstoffmittel miteinander verbunden sind, und wobei die gesamte Anordnung der Schichten (1) bis (5) mittels eines Klebstoffmittels (6) an einer aus Glas bestehenden Trägerschicht (7) befestigt ist.

2. Berührungsempfindliche Folie nach Anspruch 1, ***dadurch gekennzeichnet,* dass** die Schicht (2) des leitenden Materials vorzugsweise mittels eines Druckverfahrens auf der ersten Trägerschicht (1) angeordnet wird.

3. Berührungsempfindliche Folie nach Anspruch 1, ***dadurch gekennzeichnet,* dass** die Farbschicht (4) vorzugsweise mittels eines Druckverfahrens auf der zweiten Trägerschicht (3) angeordnet wird.

4. Berührungsempfindlicher Schalter, vorzugsweise für einen Backofen, der aus einer berührungsempfindlichen Folie nach den Ansprüchen 1 bis 3 hergestellt ist, ***dadurch gekennzeichnet,* dass** die Schicht (2) aus dem leitenden Material als wenigstens ein berührungsempfindliches Feld (9) ausgebildet ist, wobei jedes der berührungsempfindlichen Felder (9) über einen elektrischen Pol mit einem elektronischen Steuermodul verbunden ist.

5. Berührungsempfindlicher Schalter nach Anspruch 4, ***dadurch gekennzeichnet,* dass** jedes der berührungsempfindlichen Felder (9) mittels eines elektronischen Steuermoduls und über einen flexiblen Flachkabelleiter (8) mit einer elektrischen Ladung geladen wird.

6. Berührungsempfindlicher Schalter nach den Ansprüchen 4 und 5, ***dadurch gekennzeichnet,* dass** die elektrische Ladung jedes berührungsempfindlichen Felds (9) sich im Wesentlichen von einer elektrischen Ladung eines Benutzers unterscheidet.

7. Berührungsempfindlicher Schalter nach einem der Ansprüche 4 bis 6, ***dadurch gekennzeichnet,* dass** ein Piktogramm jedes berührungsempfindlichen Felds (9) ausgebildet ist, um das Licht durchzulassen, wenn es von unten beleuchtet wird.

## Revendications

1. Feuille tactile formée d'une pluralité de couches agencées les unes sur les autres et interconnectées mutuellement, **caractérisée par le fait que** sur une première couche support (1) est agencée une couche (2) d'un matériau conducteur, et sur la couche (2) du matériau conducteur est agencée une seconde couche support (3) sur laquelle est fixée une couche colorée (4), la première couche support (1) comportant la couche (2) du matériau conducteur et la seconde couche support (3) comportant la couche colorée (4) étant interconnectées mutuellement au moyen d'une couche (5) d'un moyen adhésif, et la totalité de l'assemblage des couches (1) à (5) étant fixée au moyen d'un moyen adhésif (6) sur une couche support (7) faite de verre.

2. Feuille tactile selon la revendication 1, **caractérisée par le fait que** ladite couche (2) du matériau conducteur est disposée sur ladite première couche support (1), de préférence au moyen d'un procédé d'impression.

3. Feuille tactile selon la revendication 1, **caractérisée par le fait que** ladite couche colorée (4) est disposée sur ladite seconde couche de support (3), de préférence au moyen d'un procédé d'impression.

4. Interrupteur tactile, de préférence pour un four, fait d'une feuille tactile selon l'une des revendications 1 à 3, **caractérisé par le fait que** ladite couche (2) du matériau conducteur est formée sous la forme d'au moins un champ tactile (9), chacun desdits champs tactiles (9) étant connecté par l'intermédiaire d'un pôle électrique unique à un module électronique de commande.

5. Interrupteur tactile selon la revendication 4, **caractérisé par le fait que** chacun desdits champs tactiles (9) est chargé au moyen d'un module électronique de commande et par l'intermédiaire d'un câble conducteur plat souple (8) avec une charge électrique.

6. Interrupteur tactile selon l'une des revendications 4 et 5, **caractérisé par le fait que** la charge électrique de chaque champ tactile (9) diffère principalement d'une charge électrique d'un utilisateur.

7. Interrupteur tactile selon l'une quelconque des revendications 4 à 6, **caractérisé par le fait qu'**un pictogramme de chaque champ tactile (9) est formé de façon à permettre à la lumière de le traverser lorsqu'il est éclairé par le dessous.
